# EUROPEAN PATENT APPLICATION

(11) **EP 4 748 892 A1**
(43) Date of publication of application: **27.05.2026**
(21) Application number: 24845315.1
(22) Date of filing: 01.07.2024
(51) Int. Cl.: C08L 101/00, B32B 5/28, B32B 15/04, C08K 3/013, C08K 5/02, C08K 5/53, C08L 9/00, C08L 25/04, C08L 101/02, H05K 1/03

(54) **RESIN COMPOSITION, PREPREG, RESIN FILM, LAMINATE, PRINTED WIRING BOARD, AND SEMICONDUCTOR PACKAGE**

(30) Priority: 21.07.2023 JP 2023118878
(71) Applicant: Resonac Corporation, Tokyo 105-7325 (JP)
(72) Inventor: SATOU, Naoyosi, Tokyo 105-7325 (JP); GOZU, Shuji, Tokyo 105-7325 (JP); KAKITANI, Minoru, Tokyo 105-7325 (JP); TANIGAWA, Takao, Tokyo 105-7325 (JP); AKEBI, Ryuji, Tokyo 105-7325 (JP); TAKEGUCHI, Ayaka, Tokyo 105-7325 (JP); HORIE, Akira, Tokyo 105-7325 (JP)
(74) Representative: Hoffmann Eitle
(86) International application number: PCT/JP2024/023705
(87) International publication number: WO 2025/022933

(57) **Abstract**

Provided is a resin composition and the like, which exhibits low transmission loss and excellent flame retardancy, and is capable of improving the appearance of a laminate. The resin composition is, specifically as follows. A resin composition containing: (A) a thermosetting resin; (B) a polymer having a hydrocarbon chain or a polyether chain; (X) a phosphorus compound-based flame retardant; and (Y) a flame retardant other than the phosphorus compound-based flame retardant, in which the component (X) does not contain (X1) a filler-type flame retardant, and the component (Y) does not contain (Y1) a filler-type flame retardant, or, in which when the component (X) contains the filler-type flame retardant (X1) or the component (Y) contains the filler-type flame retardant (Y1), a total content of the filler-type flame retardant (X1) and the filler-type retardant (Y1) is 25 parts by mass or less with respect to 100 parts by mass of the solid content in the resin composition.

## Description

### Technical Field

The present disclosure relates to a resin composition, a prepreg, a resin film, a laminate, a printed wiring board, and a semiconductor package.

### Background Art

In mobile communication devices such as mobile phones, base stations thereof, network infrastructure devices such as servers and routers, and electronic devices such as large computers, the speed and capacity of signals used are increasing year by year. Accordingly, it is required that substrate materials of printed wiring boards mounted on these electronic devices reduce the transmission loss of high-frequency signal.

In recent years, in addition to the electronic devices described above, in the field of intelligent transport systems (ITS) such as automobiles and traffic systems, and in the field of near distance communication in a room, practical use or practical plan of a new system handling high frequency wireless signals has progressed. Therefore, it is expected that there will be an increasing need for substrate materials with excellent high frequency characteristics for printed wiring boards used in these fields in the future.

With regard to printed wiring boards, high flame retardancy is required from the viewpoint of safety. In printed wiring boards which require highly low transmission loss, for example, hydrocarbon-based resins that contributes to a reduction of transmission loss, such as polybutadiene and a styrene-ethylene-butylene-styrene block copolymer (SEBS), are used (for example, see PTL 1). However, although such hydrocarbon-based resins are effective in reducing transmission loss, increasing their content tends to deteriorate flame retardancy. Therefore, in resin compositions containing such hydrocarbon-based resins, it has been difficult to achieve both a reduction of transmission loss and excellent flame retardancy.

### Citation List

### Patent Literature

PTL 1: JP 2004-182851 A

### Summary of Invention

### Technical Problem

Accordingly, the present inventors have conducted investigations into achieving both a reduction of transmission loss and excellent flame retardancy in a resin composition containing a hydrocarbon-based resin by the combined use of a specific combination of flame retardants. However, it was found that both a reduction of transmission loss and excellent flame retardancy are not always achieved, and furthermore, there is a tendency for fading to occur on the surface of the laminate, resulting in poor appearance.

From the above circumstances, the present disclosure is to provide a resin composition which exhibits low transmission loss and excellent flame retardancy, and is capable of improving the appearance of a laminate. Another object of the present disclosure is to provide a prepreg, a resin film, a laminate, a printed wiring board, and a semiconductor package produced using the resin composition.

### Solution to Problem

As a result of studies to achieve the above objects, the present inventors have found that the object can be achieved by the present disclosure.

The present disclosure includes the following embodiments [1] to [15].
[1] A resin composition containing:(A) a thermosetting resin; (B) a polymer having a hydrocarbon chain or a polyether chain; (X) a phosphorus compound-based flame retardant; and (Y) a flame retardant other than the phosphorus compound-based flame retardant, in which the component (X) does not contain (X1) a filler-type flame retardant, and the component (Y) does not contain (Y1) a filler-type flame retardant, or, in which when the component (X) contains the filler-type flame retardant (X1) or the component (Y) contains the filler-type flame retardant (Y1), a total content of the filler-type flame retardant (X1) and the filler-type retardant (Y1) is 25 parts by mass or less with respect to 100 parts by mass of the solid content in the resin composition.
[2] The resin composition according to the above item [1], in which the component (X) contains a (X2) compatible flame retardant.
[3] The resin composition according to the above item [1] or [2], in which the component (Y) contains (Y2) a compatible flame retardant.
[4] The resin composition according to any one of the above items [1] to [3], in which the component (A) contains at least one selected from the group consisting of an epoxy resin, a maleimide compound, a phenol resin, a polyimide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin.
[5] The resin composition according to any one of the above items [1] to [4], in which the component (B) is at least one selected from the group consisting of a conjugated diene polymer, a styrene-based elastomer, and a modified product thereof.
[6] The resin composition according any one of the above items [1] to [5], in which the component (X) contains at least one selected from the group consisting of (X-i) a phosphate compound, (X-ii) a phosphine oxide compound, (X-iii) a phosphaphenanthrene compound, (X-iv) a metal salt of phosphinic acid, and (X-v) a nitrogen-containing organic phosphorus compound.
[7] The resin composition according to any one of the above items [1] to [6], in which the component (X) contains two or more phosphorus atoms in one molecule.
[8] The resin composition according to any one of the above items [1] to [7], in which the component (Y) is a halogen-based flame retardant.
[9] The resin composition according to any one of the above items [1] to [8], further containing: (C) an inorganic filler.
[10] The resin composition according to any one of the above items [1] to [9], further containing (D) a curing accelerator.
[11] A prepreg containing the resin composition according to any one of the above items [1] to [10] or a semi-cured product of the resin composition.
[12] A resin film containing the resin composition according to any one of the above items [1] to [10] or a semi-cured product of the resin composition.
[13] A laminate containing one or more selected from the group consisting of a cured product of the resin composition according to any one of the above items [1] to [10], a cured product of the prepreg according to the above item [11], and a cured product of the resin film according to the above item [12]; and a metal foil.
[14] A printed wiring board containing one or more selected from the group consisting of a cured product of the resin composition according to any one of the above items [1] to [10]; a cured product of the prepreg according to the above item [11]; a cured product of the resin film according to the above item [12]; and the laminate according to the above item [13].
[15] A semiconductor package containing the printed wiring board according to the above item [14], and a semiconductor element.

### Advantageous Effects of Invention

According to the present disclosure, a resin composition which exhibits low transmission loss and excellent flame retardancy, and is capable of improving the appearance of a laminate, can be provided. In addition, a prepreg, a resin film, a laminate, a printed wiring board, and a semiconductor package produced using the resin composition, can be provided.

### Description of Embodiments

In the numerical range described in the present disclosure, the upper limit value or the lower limit value of the numerical range may be replaced by the value described in the Examples. In addition, the lower limit value and the upper limit value of the numerical range are arbitrarily combined with the lower limit value or the upper limit value of another numerical range, respectively. In the notation of the numerical range "AA to BB", the numerical values AA and BB at both ends are included in the numerical range as the lower limit value and the upper limit value, respectively.

In the present disclosure, for example, the description of "10 or more" means 10 and a numerical value exceeding 10, and the same applies to a case where the numerical value is different. Further, for example, the description of "10 or less" means 10 and a numerical value less than 10, and the same applies to a case where the numerical value is different.

The components and materials exemplified in the present disclosure may be used alone or in combination of two or more kinds thereof, unless otherwise specified. In the present disclosure, the content of each component (for example, component (A)) in the resin composition refers to the total amount of a plurality of substances present in the resin composition unless otherwise specified, when there are a plurality of substances corresponding to the respective components in the resin composition.

In the present disclosure, the "resin component" is defined as all components excluding inorganic compounds such as (C) an inorganic filler which will be described later among the solid contents constituting the resin composition.

In the present disclosure, the "solid content" means the components in the resin composition other than the organic solvent which will be described later, and components that are in liquid form at room temperature of approximately 25°C are also regarded as solid content.

The expression "containing XX" described in the present disclosure, when XX can react, includes both the case where XX may be contained in a reacted state, and the case where XX may be simply contained.

An aspect in which matters described in the present disclosure are arbitrarily combined is also included in the present disclosure and the present embodiment.

### [Resin Composition]

The present embodiment is the following resin composition.

A resin composition containing:
(A) a thermosetting resin;
(B) a polymer having a hydrocarbon chain or a polyether chain;
(X) a phosphorus compound-based flame retardant; and
(Y) a flame retardant other than the phosphorus compound-based flame retardant,

in which the component (X) does not contain (X1) a filler-type flame retardant, and the component (Y) does not contain (Y1) a filler-type flame retardant, or,
in which when the component (X) contains the filler-type flame retardant (X1) or the component (Y) contains the filler-type flame retardant (Y1), a total content of the filler-type flame retardant (X1) and the filler-type retardant (Y1) is 25 parts by mass or less with respect to 100 parts by mass of the solid content in the resin composition.

The components contained in the resin composition of the present embodiment will be described in detail below.

### ((A) Thermosetting Resin)

Examples of the component (A) include an epoxy resin, a maleimide compound, a phenol resin, a polyimide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin. Among these, the component (A) preferably contains at least one selected from the group consisting of an epoxy resin, a maleimide compound, a phenol resin, a polyimide resin, a cyanate resin, and an isocyanate resin, more preferably contains at least one selected from the group consisting of an epoxy resin and a maleimide compound, and even more preferably contains a maleimide compound from the viewpoint of low thermal expansion and the like.

The component (A) may be used alone, or in combination of two or more kinds thereof.

The epoxy resin is preferably an epoxy resin having two or more epoxy groups in one molecule. The epoxy resin herein is classified into a glycidyl ether type epoxy resin, a glycidyl amine type epoxy resin, a glycidyl ester type epoxy resin, and the like. Among these, a glycidyl ether type epoxy resin is preferable.

Epoxy resins are also classified into various epoxy resins depending on the main backbone, and in each of the above types of epoxy resins, epoxy resins are further classified into bisphenol type epoxy resins such as bisphenol A type epoxy resin, bisphenol F type epoxy resin, and bisphenol S type epoxy resin; alicyclic epoxy resins such as dicyclopentadiene type epoxy resin; aliphatic linear epoxy resins; novolac type epoxy resins such as phenol novolac type epoxy resin, cresol novolac type epoxy resin, bisphenol A novolac type epoxy resin, bisphenol F novolac type epoxy resin, phenol aralkyl novolac type epoxy resin, and biphenyl aralkyl novolac type epoxy resin; stilbene type epoxy resins; naphthalene skeleton-containing epoxy resins such as naphthol novolac type epoxy resin and naphthol aralkyl type epoxy resin; biphenyl type epoxy resins; xylylene type epoxy resins; and dihydroanthracene type epoxy resins.

The maleimide compound preferably contains at least one selected from the group consisting of a maleimide compound having one or more N-substituted maleimide groups and a derivative of the maleimide compound. The maleimide compound having one or more N-substituted maleimide groups is preferably a maleimide compound having two or more N-substituted maleimide groups, more preferably a maleimide compound having 2 to 10 N-substituted maleimide groups, even more preferably a maleimide compound having 2 to 5 N-substituted maleimide groups, and particularly preferably a maleimide compound having two N-substituted maleimide groups.

In addition, the maleimide compound having two or more N-substituted maleimide groups is preferably a compound in which nitrogen atoms of the maleimide groups are bonded to each other via an organic group.

Examples of the maleimide compound having one or more N-substituted maleimide groups include, but are particularly not limited to, an aromatic maleimide compound having one N-substituted maleimide group preferably bonded to an aromatic ring, such as N-phenylmaleimide, N-(2-methylphenyl)maleimide, N-(4-methylphenyl)maleimide, N-(2,6-dimethylphenyl)maleimide, N-(2,6-diethylphenyl)maleimide, N-(2-methoxyphenyl)maleimide, and N-benzylmaleimide; an aromatic bismaleimide compound having two N-substituted maleimide groups preferably bonded to an aromatic ring, such as 4,4'-diphenylmethane bismaleimide, bis(4-maleimidophenyl)ether, bis(4-maleimidophenyl)sulfone, 3,3'-dimethyl-5,5'-diethyl-4,4'-diphenylmethane bismaleimide, 4-methyl-1,3-phenylene bismaleimide, m-phenylene bismaleimide, 2,2-bis[4-(4-maleimidophenoxy)phenyl]propane, and an indane ring-containing aromatic bismaleimide; an aromatic polymaleimide compound having three or more N-substituted maleimide groups preferably bonded to an aromatic ring, such as polyphenylmethane maleimide and biphenyl aralkyl type maleimide; and an aliphatic maleimide compound such as N-dodecylmaleimide, N-isopropylmaleimide, N-cyclohexylmaleimide, 1,6-bismaleimide-(2,2,4-trimethyl)hexane, and a pyrrolidone acid binder type long chain alkyl bismaleimide. Among these, from the viewpoint of compatibility with other resins, adhesion to conductors, heat resistance, low thermal expansion, mechanical properties, and a reduction of transmission loss, an aromatic bismaleimide compound having two N-substituted maleimide groups preferably bonded to an aromatic ring and an aromatic polymaleimide compound having three or more N-substituted maleimide groups preferably bonded to an aromatic ring are more preferable, and an indane ring-containing aromatic bismaleimide and a biphenyl aralkyl type maleimide are even more preferable. In the present disclosure, the indane ring refers to a fused bicyclic structure of an aromatic 6-membered ring and a saturated aliphatic 5-membered ring. The indane ring-containing aromatic bismaleimide preferably has a divalent group represented by the following general formula (a1-1).

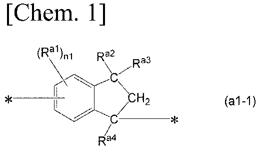

(In the formula, R^{a1} is an alkyl group having 1 to 10 carbon atoms, an alkyloxy group having 1 to 10 carbon atoms, an alkylthio group having 1 to 10 carbon atoms, an aryl group having 6 to 10 carbon atoms, an aryloxy group having 6 to 10 carbon atoms, an arylthio group having 6 to 10 carbon atoms, a cycloalkyl group having 3 to 10 carbon atoms, a halogen atom, a hydroxy group, or a mercapto group, and n1 is an integer of 0 to 3. R^{a2} to R^{a4} are each independently an alkyl group having 1 to 10 carbon atoms. * denotes a binding site.)

The indane ring-containing aromatic bismaleimide containing a divalent group represented by the general formula (a1-1) is preferably one represented by the following general formula (a1-2) from the viewpoint of a reduction of transmission loss, adhesion to conductors, heat resistance, and ease of production.

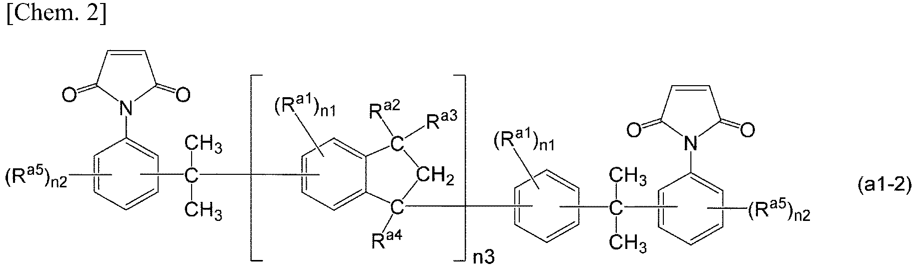

(In the formula, R^{a1} to R^{a4} and n1 are the same as in the general formula (a1-1). R^{a5} is each independently an alkyl group having 1 to 10 carbon atoms, an alkyloxy group having 1 to 10 carbon atoms, an alkylthio group having 1 to 10 carbon atoms, an aryl group having 6 to 10 carbon atoms, an aryloxy group having 6 to 10 carbon atoms, an arylthio group having 6 to 10 carbon atoms, a cycloalkyl group having 3 to 10 carbon atoms, a halogen atom, a nitro group, a hydroxy group, or a mercapto group, n2 is each independently an integer of 0 to 4, and n3 is a number of 0.95 to 10.0.)

The indane ring-containing aromatic bismaleimide represented by the general formula (a1-2) is more preferably one represented by the following general formula (a1-3), or more preferably one represented by the following general formula (a1-4), from the viewpoints of a reduction of transmission loss, adhesion to conductors, solvent solubility, and ease of production.

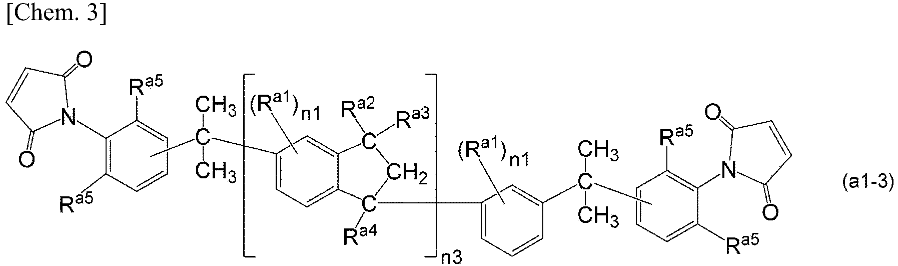

(In the formula, R^{a1} to R^{a5} and n1 and n3 are the same as in the general formula (a1-2).)

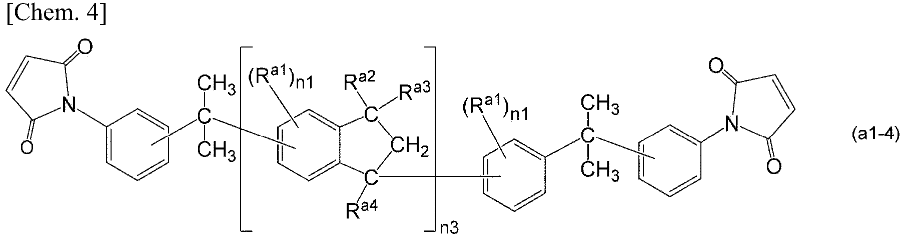

(In the formula, R^{a1} to R^{a4} and n1 and n3 are the same as in the general formula (a1-2).)

There are no limitation on the method for producing an indane ring-containing aromatic bismaleimide, and it may be produced by known methods.

Examples of the "derivative" of the maleimide compound include an addition reaction product of the maleimide compound having one or more (preferably two or more) N-substituted maleimide groups and one or more amine compounds selected from the group consisting of a monoamine compound, a diamine compound, and the like.

Examples of the monoamine compound include monoamine compounds having an acidic substituent, such as o-aminophenol, m-aminophenol, p-aminophenol, o-aminobenzoic acid, m-aminobenzoic acid, p-aminobenzoic acid, o-aminobenzenesulfonic acid, m-aminobenzenesulfonic acid, p-aminobenzenesulfonic acid, 3,5-dihydroxyaniline, and 3,5-dicarboxyaniline.

Examples of the diamine compound include diamine compounds having an aromatic hydrocarbon group such as 4,4'-diaminodiphenylmethane, 4,4'-diaminodiphenylethane, 4,4'-diaminodiphenylpropane, 2,2'-bis(4,4'-diaminodiphenyl)propane, 3,3'-dimethyl-4,4'-diaminodiphenylmethane, 3,3'-diethyl-4,4'-diaminodiphenylmethane, 3,3'-dimethyl-4,4'-diaminodiphenylethane, 3,3'-diethyl-4,4'-diaminodiphenylethane, 4,4'-diaminodiphenyl ether, 4,4'-diaminodiphenyl thioether, 3,3'-dihydroxy-4,4'-diaminodiphenylmethane, 2,2',6,6'-tetramethyl-4,4'-diaminodiphenylmethane, 3,3'-dichloro-4,4'-diaminodiphenylmethane, 3,3'-dibromo-4,4'-diaminodiphenylmethane, 2,2',6,6'-tetrachloro-4,4'-diaminodiphenylmethane, 2,2',6,6'-tetrabromo-4,4'-diaminodiphenylmethane, and siloxane diamine.

### (Content of the Component (A))

The content of the thermosetting resin (A) in the resin composition of the present embodiment is not particularly limited, and from the viewpoint of heat resistance, moldability, and the like, is preferably 3 to 95 parts by mass, more preferably 5 to 80 parts by mass, even more preferably 5 to 60 parts by mass, particularly preferably 5 to 45 parts by mass, and most preferably 7 to 30 parts by mass, with respect to 100 parts by mass of the solid content in the resin composition.

### <(B) Polymer Having Hydrocarbon Chain or Polyether Chain>

The resin composition of the present embodiment contains a polymer having a hydrocarbon chain or a polyether chain as the component (B) from the viewpoint of a reduction of transmission loss. A polymer having a hydrocarbon chain or a polyether chain is preferably a polymer having a hydrocarbon chain or a polyether chain in main chain. In the present disclosure, the "main chain" represents the relatively longest bond chain in the polymer molecule, and a "side chain" in the present embodiment represents an atomic group branched from the main chain. In addition, the "hydrocarbon chain" means a structure in which carbon atoms bonded to hydrogen atoms are linked in a chain. In addition, the "polyether chain" means a structure in which units containing polyether bonds are linked in a chain.

The component (B) may be used alone or in combination of two or more thereof.

As the polymer having a hydrocarbon chain, at least one selected from the group consisting of a conjugated diene polymer, a styrene-based elastomer, and a modified product thereof, is preferred. Hereinafter, the modified products of conjugated diene polymers may be referred to as modified conjugated diene polymers. As the modified conjugated diene polymer, a conjugated diene polymer modified with the above maleimide compound is preferred, and a conjugated diene polymer modified with a maleimide compound having two or more N-substituted maleimide groups is more preferred.

In addition, examples of the polymer having a polyether chain include a polyphenylene ether and a modified product of polyphenylene ether.

Of these, from the viewpoint of compatibility with other resins, a reduction of transmission loss and heat resistance, as the component (B), a polymer having a hydrocarbon chain is preferred, and a modified conjugated diene polymer and a styrene-based elastomer are more preferred. Furthermore, from the viewpoints of compatibility with other resins, a reduction of transmission loss, and heat resistance, a conjugated diene polymer having a vinyl group in a side chain is preferred as the conjugated diene polymer.

Hereinafter, the conjugated diene polymer having a vinyl group in the side chain may be referred to as "(B1) conjugated diene polymer" or "component (B1)", and the styrene-based elastomer may be referred to as "(B2) styrene-based elastomer" or "component (B2)". The component (B1) and the component (B2) will be described in order.

### ((B1) Conjugated Diene Polymer)

The component (B1) is a conjugated diene polymer having a vinyl group in side chains thereof. By using the component (B1) as the component (B), the dielectric dissipation factor (Df) of the resulting cured product of the resulting resin composition tends to improve further, thereby reducing transmission loss.

The component (B1) may be used alone or in combination of two or more thereof.

The component (B1) is preferably a conjugated diene polymer having a plurality of vinyl groups in side chains thereof. The number of vinyl groups that the component (B1) has in one molecule is not particularly limited; however, from the viewpoint of a reduction of transmission loss and heat resistance, it is preferably 3 or more, more preferably 5 or more, and even more preferably 10 or more.

In the present disclosure, a conjugated diene polymer refers to a polymer of a conjugated diene compound.

Examples of the conjugated diene compound include 1,3-butadiene, isoprene, 1,3-pentadiene, 2,3-dimethyl-1,3-butadiene, 2-phenyl-1,3-butadiene, and 1,3-hexadiene.

The conjugated diene polymer may be a polymer of one conjugated diene compound or a polymer of two or more conjugated diene compounds.

Further, the conjugated diene polymer may be obtained by copolymerizing one or more conjugated diene compounds and one or more monomers other than the conjugated diene compounds. The polymerization mode in that case is not particularly limited, and may be a random polymerization, a block polymerization or a graft polymerization.

Specific examples of the component (B1) include a polybutadiene having a 1,2-vinyl group, a butadiene-styrene copolymer having a 1,2-vinyl group, and a polyisoprene having a 1,2-vinyl group. Of these, from the viewpoint of a reduction of transmission loss and heat resistance, a polybutadiene having a 1,2-vinyl group and a butadiene-styrene copolymer having a 1,2-vinyl group are preferable, and a polybutadiene having a 1,2-vinyl group is more preferable. In addition, the polybutadiene having a 1,2-vinyl group is preferably a butadiene homopolymer having a 1,2-vinyl group.

The butadiene-derived 1,2-vinyl group of the component (B1) is a vinyl group contained in a butadiene-derived structural unit represented by the following formula (b1-1).

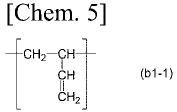

When the component (B1) is a polybutadiene having a 1,2-vinyl group, the content of structural units having a 1,2-vinyl group with respect to all butadiene-derived structural units constituting polybutadiene [hereinafter sometimes referred to as "vinyl group content".] is not particularly limited; however, it is preferably 50 mol% or more, more preferably 60 mol% or more, even more preferably 70 mol% or more, particularly preferably 80 mol% or more, and most preferably 85 mol% or more, from the viewpoint of compatibility with other resins, a reduction of transmission loss, low thermal expansion and heat resistance. In addition, the upper limit of the vinyl group content is not particularly limited, and may be 100 mol% or less, 97 mol% or less, or 95 mol% or less. The structural unit having a 1,2-vinyl group is preferably a butadiene-derived structural unit represented by the above formula (b1-1).

From the same point of view, the polybutadiene having a 1,2-vinyl group is preferably a 1,2-polybutadiene homopolymer.

The number average molecular weight of the component (B1) is not particularly limited; however, from the viewpoint of compatibility with other resins, a reduction of transmission loss, low thermal expansion and heat resistance, it is preferably 400 to 4,000, more preferably 500 to 3,000, even more preferably 600 to 2,000, and particularly preferably 700 to 1,500.

### ((B2) Styrene-based Elastomer)

The component (B2) is not particularly limited as long as it is an elastomer having a structural unit derived from a styrene-based compound. By containing the component (B2) in the component (B), the dielectric dissipation factor (Df) of the obtained cured product of the resulting resin composition tends to improve further, thereby reducing transmission loss.

The component (B2) may be used alone or in combination of two or more thereof.

The component (B2) preferably has a styrene-derived structural unit represented by the following general formula (b2-1).

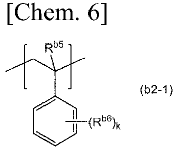

(In the formula, R^{b5} is a hydrogen atom or an alkyl group having 1 to 5 carbon atoms, R^{b6} is an alkyl group having 1 to 5 carbon atoms, and k is an integer of 0 to 5.)

Examples of the alkyl group having 1 to 5 carbon atoms represented by R^{b5} and R^{b6} include a methyl group, an ethyl group, and an n-propyl group. Of these, an alkyl group having 1 to 3 carbon atoms is preferred, an alkyl group having 1 or 2 carbon atoms is more preferred, and a methyl group is even more preferred.

k is preferably an integer of 0 to 2, more preferably 0 or 1, and even more preferably 0.

Examples of a structural unit other than the structural units derived from a styrene-based compound of the component (B2) include a structural unit derived from butadiene, a structural unit derived from isoprene, a structural unit derived from maleic acid, and a structural unit derived from maleic anhydride.

The structural unit derived from butadiene and the structural unit derived from isoprene may be hydrogenated. When hydrogenated, the structural unit derived from butadiene becomes a structural unit in which an ethylene unit and a butylene unit are mixed, and the structural unit derived from isoprene becomes a structural unit in which an ethylene unit and a propylene unit are mixed.

From the viewpoint of a reduction of transmission loss, adhesion to conductors, heat resistance, and low thermal expansion, the component (B2) is preferably one or more selected from the group consisting of a hydrogenated product of styrene-butadiene-styrene block copolymer (SEBS and SBBS), a hydrogenated product of styrene-isoprene-styrene block copolymer (SEPS), and a styrene-maleic anhydride copolymer (SMA), more preferably one or more selected from the group consisting of SEBS and SEPS, and even more preferably SEBS. Here, the SEBS is obtained by hydrogenating the butadiene unit of a styrene-butadiene-styrene block copolymer (SBS) and is named by taking the initial letters of each of styrene-ethylene-butylene-styrene, and the SBBS is obtained by selectively hydrogenating the 1,2-bond unit in the butadiene unit of the styrene-butadiene-styrene block copolymer (SBS) and is named by taking the initial letters of each of styrene-(1,4-butadiene)-butylene-styrene. Further, SEPS is a hydrogenated product in which the isoprene units of a styrene-isoprene-styrene (SIS) block copolymer are hydrogenated, and its name is derived from the initials of styrene-ethylenepropylene-styrene.

In the above SEBS, although the content of structural units derived from styrene [hereinafter sometimes referred to as "styrene content".] is not particularly limited, it is preferably 5 to 80% by mass, more preferably 10 to 75% by mass, even more preferably 15 to 70% by mass, further preferably 20 to 50 % by mass, and particularly preferably 25 to 45% by mass, from the viewpoint of low thermal expansion properties, a reduction of transmission loss, adhesion to conductors, and heat resistance.

Examples of commercially available products of SEBS include Tuftec H series and M series manufactured by Asahi Kasei Corporation, Septon series manufactured by Kuraray Co., Ltd., and Kraton G polymer series manufactured by Kraton Polymer Japan Co., Ltd.

Although the weight average molecular weight (Mw) of the component (B2) is not particularly limited, it is preferably 12,000 to 1,000,000, more preferably 30,000 to 500,000, even more preferably 50,000 to 200, 000, and particularly preferably 70,000 to 150,000, most preferably 90,000 to 130,000. The weight-average molecular weight (Mw) is measured by gel permeation chromatography (GPC) in terms of polystyrene, and more specifically, a value measured by a measurement method described in Examples.

### [Content ratio of Conjugated Diene Polymer (B1) and Styrene-based Elastomer (B2)]

In the resin composition of the present embodiment, when the component (B1) and the component (B2) are used together, although the content ratio of the component (B1) and the component (B2): [(B1)/(B2)] is not particularly limited, from the viewpoint of moldability, compatibility with other resins and a reduction of transmission loss, it is preferably 2/98 to 70/30, more preferably 5/95 to 60/40, even more preferably 10/90 to 50/50, and particularly preferably 20/80 to 40/60 on a mass basis.

### (Content of the Component (B))

The content of the component (B) in the resin composition of the present embodiment is not particularly limited, but is preferably 3 to 35 parts by mass, more preferably 5 to 30 parts by mass, even more preferably 10 to 30 parts by mass, particularly preferably 15 to 30 parts by mass, most preferably 15 to 25 parts by mass, with respect to 100 parts by mass of the solid content in the resin composition. When the content of the component (B) is 3 parts by mass or more with respect to 100 parts by mass of the solid content in the resin composition, there is a tendency for a reduction of transmission loss, and when it is 35 parts by mass or less, there is a tendency to maintain favorable heat resistance and flame retardancy.

### ((X) Phosphorus compound-based flame retardant)

The resin composition of the present embodiment contains a phosphorus compound-based flame retardant as the component (X). Phosphorus compound-based flame retardants have a flame retardant mechanism in which a coating film of a phosphoric acid-layer generated by decomposition blocks oxygen, and furthermore, through a dehydration effect, organic substances are carbonized to form a film called a char on the surface of the burnt product, thereby blocking oxygen.

Phosphorus compound-based flame retardants include phosphorus oxide compounds. Here, "phosphorus oxide compound" means a compound having a following phosphorus oxide structure.

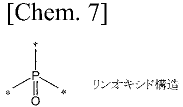

### Phosphorus oxide structure

(* represents a binding site.)

The aromatic ring contained in the component (X) is preferably an aromatic ring having 6 to 18 ring carbon atoms, and examples thereof include a benzene ring, a naphthalene ring, and an anthracene ring. As the aromatic ring, a benzene ring is preferred. The aromatic ring may have a substituent or may not have a substituent. Examples of substituents in which the aromatic ring may have include alkyl groups having 1 to 6 carbon atoms, such as methyl group, ethyl group, n-propyl group, isopropyl group, n-butyl group, and t-butyl group; and alkoxy groups such as methoxy group, ethoxy group, and isopropoxy group. The substituent is preferably an alkyl group having 1 to 6 carbon atoms, more preferably an alkyl group having 1 to 3 carbon atoms, and even more preferably a methyl group.

The component (X) preferably contains two or more aromatic rings per molecule, more preferably 2 to 10, even more preferably 2 to 6, particularly preferably 4 to 6, and most preferably contains 5 aromatic rings. Here, when the component (X) contains two or more aromatic rings per molecule, the multiple aromatic rings may be the same or different, but it is preferable that they are the same.

The component (X) may have the aromatic ring directly bonded to a phosphorus atom, or bonded to the phosphorus atom via an oxygen atom, or bonded to the phosphorus atom via an alkylene group such as a methylene group.

The component (X) preferably contains two or more phosphorus atoms in one molecule, more preferably 2 to 4 phosphorus atoms in one molecule, and even more preferably 2 phosphorus atoms in one molecule, from the viewpoint of low thermal expansion, high elasticity, and a reduction of transmission loss.

As the component (X), it is not particularly limited, however, from the viewpoint of low thermal expansion, high elasticity, and a reduction of transmission loss, it is preferable to contain at least one selected from the group consisting of (X-i) a phosphate compound, (X-ii) a phosphine oxide compound, (X-iii) a phosphaphenanthrene compound, (X-iv) a metal salt of phosphinic acid, and (X-v) a nitrogen-containing organic phosphorus compound; more preferably, at least one selected from the group consisting of (X-i) a phosphate compound, (X-ii) a phosphine oxide compound, and (X-iv) a metal salt of phosphinic acid; and even more preferably, at least one selected from the group consisting of (X-ii) a phosphine oxide compound and (X-iv) a metal salt of phosphinic acid.

Hereinafter, the components (X-i) to (X-v) will be described in detail in this order.

### ((X-i) Phosphate compound)

The phosphate compound may be used alone or in combination of two or more kinds thereof. As the phosphate compound, a commercially available product can be used.

The component (X-i) preferably has two or more phosphate groups in the molecule, and more preferably has two phosphate groups in the molecule. Here, the phosphate group is a group represented by the following formula.

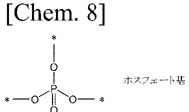

### Phosphate group

(* represents a binding site.)

The phosphate compound having two or more phosphate groups in the molecule preferably contains a linking group that links the two or more phosphate groups. The linking group is not particularly limited, and examples thereof include a phenylene group, a xylylene group, a biphenylene group, a naphthylene group, a methylene group, and an ethylene group. From the viewpoint of the component (X-i) having a high melting point, the linking group is preferably at least one selected from the group consisting of a phenylene group, a xylylene group, a biphenylene group, and a naphthylene group, and more preferably includes a phenylene group.

From the viewpoint of low thermal expansion, high elasticity, and a reduction of transmission loss, the oxygen atom which is contained in the phosphate group may be substituted by the aromatic ring.

From the viewpoint of improving the adhesive strength to the metal foil and the heat resistance for soldering while maintaining a low thermal expansion property, the component (X-i) is preferably a compound represented by the following general formula (X-1).

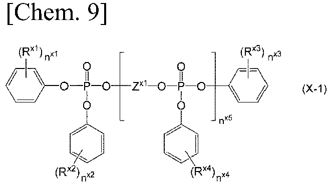

(In the formula, R^{x1} to R^{x4} each independently represent an aliphatic hydrocarbon group having 1 to 5 carbon atoms. Z^{x1} represents a divalent group represented by the following general formula (X-2) or a divalent fused polycyclic aromatic hydrocarbon group. n^{x1} to n^{x4} each independently represent an integer of 0 to 5, and n^{x5} represents an integer of 0 to 5.)

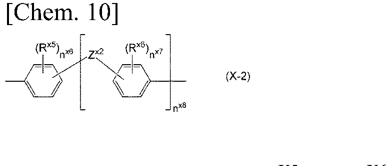

(In the formula, R^{X5} and R^{X6} represent each independently an aliphatic hydrocarbon group having 1 to 5 carbon atoms or a halogen atom; Z^{X2} is an alkylene group having 1 to 5 carbon atoms, an alkylidene group having 2 to 5 carbon atoms, -O-, -S-, a sulfonyl group, a carbonyloxy group, a keto group, or a single bond; n^{X6} and n^{X7} are each independently an integer of 0 to 4; and n^{X8} represents an integer of 0 to 3.)

Examples of the aliphatic hydrocarbon group having 1 to 5 carbon atoms represented by R^{X1} to R^{X4} in the general formula (X-1) include a methyl group, an ethyl group, a n-propyl group, an isopropyl group, a n-butyl group, an isobutyl group, a t-butyl group, and an n-pentyl group. The aliphatic hydrocarbon group is preferably an aliphatic hydrocarbon group having 1 to 3 carbon atoms, more preferably an alkyl group having 1 to 3 carbon atoms, and even more preferably a methyl group.

n^{X1} and n^{X4} each represent an integer of 0 to 5, preferably an integer of 0 to 2, more preferably 0 or 2, and even more preferably 2. When n^{X1} to n^{X4} is an integer of 2 or more, a plurality of R^{X1}'s, R^{X2}'s, R^{X3}'s, or R^{X4}'s may be the same as or different from each other.

n^{X5} represents an integer of 0 to 5, preferably an integer of 1 to 3, more preferably 1 or 2, and even more preferably 1. When n^{X5} is an integer of 2 or more, a plurality of Z^{X1}'s or a plurality of n^{X4}'s may be the same as or different from each other.

The definitions of each group in the general formula (X-2) are as described above.

Examples of the aliphatic hydrocarbon group having 1 to 5 carbon atoms represented by R^{x5} and R^{x6} include the same as the aliphatic hydrocarbon groups having 1 to 5 carbon atoms represented by R^{x1} to R^{x4} in the general formula (X-1) above.

Examples of the halogen atom represented by R^{X5} and R^{X6} include a fluorine atom, a chlorine atom, a bromine atom, and an iodine atom.

Examples of the alkylene group having 1 to 5 carbon atoms represented by Z^{X2} include a methylene group, a 1,2-dimethylene group, a 1,3-trimethylene group, a 1,4-tetramethylene group, and a 1,5-pentamethylene group.

Examples of the alkylidene group having 2 to 5 carbon atoms represented by Z^{X2} include an ethylidene group, a propylidene group, an isopropylidene group, a butylidene group, an isobutylidene group, a pentylidene group, and an isopentylidene group.

n^{x6} and n^{X7} each independently represent an integer of 0 to 4, preferably 0 or 1, and more preferably 0.

n^{x8} is an integer of 0 to 3, preferably 0 or 1, more preferably 0.

The general formula (X-2) is preferably a following general formula (X-2-1).

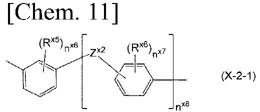

(In the formula, the definition of each group is the same as the definition of each group in general formula (X-2).)

Examples of the divalent fused polycyclic aromatic hydrocarbon group represented by z^{x1} in general formula (X-1) include divalent groups obtained by removing two hydrogen atoms from a fused polycyclic aromatic hydrocarbon such as naphthalene, anthracene, or pyrene. These fused polycyclic aromatic hydrocarbon groups may or may not be substituted with a substituent. Examples of substituents of the fused polycyclic aromatic hydrocarbon group include: aliphatic hydrocarbon groups having 1 to 5 carbon atoms such as methyl group, ethyl group, n-propyl group, isopropyl group, n-butyl group, isobutyl group, t-butyl group, and n-pentyl group; and halogen atoms such as fluorine atom, chlorine atom, bromine atom, and iodine atom.

Specific examples of the phosphate compound (X-i) include: 1,3-phenylene-bis(di-2,6-dimethylphenyl phosphate), 1,3-phenylene-bis(diphenyl phosphate), bisphenol A bis(diphenyl phosphate), 1,4-phenylene-bis(di-2,6-dimethylphenyl phosphate), 4,4'-biphenylene-bis(di-2,6-dimethylphenyl phosphate), bisphenol A polyphenyl phosphate, 4,4'-biphenol polycresyl phosphate, bisphenol A polycresyl phosphate, 4,4'-biphenol poly(2,6-xylylene phosphate), and bisphenol A poly(2,6-xylylene phosphate).

In addition, "poly" in the above specific example of the phosphate compounds means a compound having two or more structural units composed of a structure derived from a divalent phenol compound and a structure derived from phosphoric acid that constitutes the phosphate compound, and may also mean a compound in which the average number of the structural units exceeds 1 due to the inclusion of the compound. Here, the "structural unit" refers to, for example, the structural unit in brackets in the general formula (X-1).

### ((X-ii) Phosphine oxide compound)

The phosphine oxide compounds may be used alone or in combination of two or more kinds thereof. As the phosphine oxide compound, a commercially available product can be used.

The component (X-ii) preferably has two or more diphenylphosphine oxide groups in the molecule, and more preferably has two diphenylphosphine oxide groups in the molecule. Here, the diphenylphosphine oxide group is a group represented by the following formula.

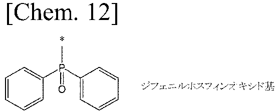

### Diphenylphosphine oxide group

(* represents a binding site.)

The melting point of the component (X-ii) is preferably 280°C or higher and more preferably 310°C or higher, from the viewpoint of a reduction of transmission loss. The melting point of the phosphine oxide compound is limited to around 450°C from the viewpoint of the decomposition temperature of organic substances. For this reason, the melting point of the component (X-ii) is preferably 280 to 450°C, and more preferably 310 to 450°C. The melting point can be measured using a thermogravimetric/differential thermal analyzer (TG/DTA).

A phosphine oxide compound having two or more diphenylphosphine oxide groups in the molecule preferably has a linking group that links the two or more diphenylphosphine oxide groups. The linking group is not particularly limited, and examples thereof include a phenylene group, a xylylene group, a biphenylene group, a naphthylene group, a methylene group, and an ethylene group. From the viewpoint of the component (X-ii) having a high melting point, the linking group is preferably at least one selected from the group consisting of a phenylene group, a xylylene group, a biphenylene group, and a naphthylene group, and more preferably includes a phenylene group.

The specific examples of the component (X-ii) include the following compound.

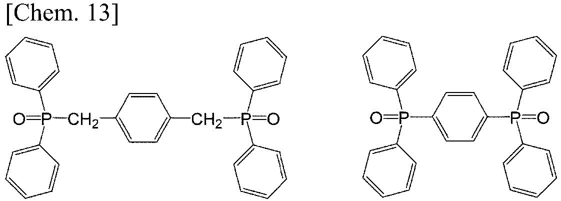

### ((X-iii) Phosphaphenanthrene compound)

The phosphaphenanthrene compound may be used alone or in combination of two or more kinds thereof. As the phosphaphenanthrene compound, a commercially available product can be used.

Examples of the component (X-iii) include compounds represented by the following formula (X-3).

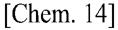

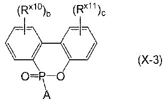

(In the formula, R^{x10} and R^{x11} each independently represent a hydrogen atom or a hydrocarbon group having 1 or more and 6 or less carbon atoms. b and c each independently represent an integer of 0 or more and 4 or less. A is a hydrogen atom or a group represented by any one of the following formulas (X-4) to (X-6).)

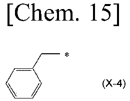

(* represents a binding site.)

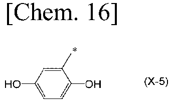

(* represents a binding site.)

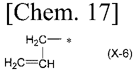

(* represents a binding site.)

Examples of the component (X-iii) include 9,10-dihydro-9-oxa-10-phosphaphenanthrene 10-oxide, 9,10-dihydro-10-(2,5-dihydroxyphenyl)-9-oxa-10-phosphaphenanthrene 10-oxide.

### ((X-iv) Metal salt of phosphinic acid)

The component (X-iv) is preferably a metal salt of dialkylphosphinic acid. Here, examples of the "metal salt" include lithium salts, sodium salts, potassium salts, calcium salts, magnesium salts, aluminum salts, titanium salts, and zinc salts. Among these, aluminum salts are preferred as the metal salts.

The alkyl group of the dialkylphosphinic acid may be an alkyl group having 1 to 10 carbon atoms. The alkyl group is preferably an alkyl group having 1 to 6 carbon atoms, more preferably an alkyl group having 1 to 4 carbon atoms, and even more preferably an ethyl group.

### ((X-v) Nitrogen-containing organic phosphorus compound)

The component (X-v) may be a phosphazene compound. The phosphazene compound preferably has a structural unit represented by the following general formula (X-7).

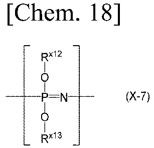

(In the formula, R^{x12} to R^{x13} each independently represent an organic group having 1 to 20 carbon atoms.)

Examples of the organic group having 1 to 20 carbon atoms represented by R^{x12} and R^{x13} in the above general formula (X-7) include an aliphatic hydrocarbon group having 1 to 20 carbon atoms and an aromatic hydrocarbon group having 6 to 20 carbon atoms.

Examples of the aliphatic hydrocarbon group having 1 to 20 carbon atoms as the organic group having 1 to 20 carbon atoms represented by R^{X12} and R^{X13} include an alkyl group having 1 to 20 carbon atoms, an alkenyl group having 2 to 20 carbon atoms, and an alkynyl group having 2 to 20 carbon atoms. The aliphatic hydrocarbon group may be linear, branched or cyclic.

Examples of the alkyl group having 1 to 20 carbon atoms include a methyl group, an ethyl group, a n-propyl group, an isopropyl group, a n-butyl group, an isobutyl group, a t-butyl group, a n-pentyl group, 2-ethylhexyl group, and a cyclohexyl group. Examples of the alkenyl group having 2 to 20 carbon atoms include a vinyl group, a propenyl group, and a butenyl group. Examples of the alkynyl group having 2 to 20 carbon atoms include a 2-propynyl group, and a 3- butynyl group.

The aliphatic hydrocarbon group having 1 to 20 carbon atoms may have a substituent or may not have a substituent. Examples of the substituent include a hydroxy group, a carboxy group, a halogen atom, an aromatic hydrocarbon group, an acyl group, an alkoxy group, and groups in which these substituents are linked. When the aliphatic hydrocarbon group has a substituent, the number of carbon atoms in the substituent is also included in the above number of carbon atoms.

The aromatic hydrocarbon group having 6 to 20 carbon atoms, which is exemplified as the organic group having 1 to 20 carbon atoms represented by R^{x12} and R^{x13}, preferably has 6 to 15 carbon atoms, and more preferably has 6 to 10 carbon atoms.

Examples of the aromatic hydrocarbon group having 6 to 20 carbon atoms include a phenyl group, a naphthyl group, a biphenyl group, and an antranyl group.

The aromatic hydrocarbon group having 6 to 20 carbon atoms may have a substituent or may not have a substituent. Examples of the substituent include a hydroxy group, a carboxy group, a halogen atom, an aliphatic hydrocarbon group, an acyl group, an alkoxy group, a cyano group, and groups in which these substituents are linked. As the substituent, a cyano group is preferred. Note that when the aromatic hydrocarbon group has a substituent, the number of carbon atoms in the substituent is also included in the above number of carbon atoms.

Among these, the organic group having 1 to 20 carbon atoms represented by R^{X12} and R^{X13} is preferably an aromatic hydrocarbon group having 6 to 20 carbon atoms, more preferably an unsubstituted phenyl group and a phenyl group having a substituent, even more preferably an unsubstituted phenyl group and a cyanophenyl group, from the viewpoint of flame retardancy.

The phosphazene compound may be a linear phosphazene compound or a cyclic phosphazene compound, however a cyclic phosphazene compound is preferred.

As the cyclic phosphazene compound, a phosphazene compound represented by the following general formula (X-8) is preferred, and a phosphazene compound represented by the following general formula (X-9) is more preferred.

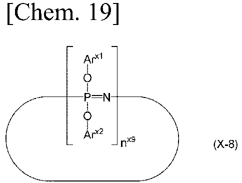

(In the formula, Ar^{x1} and Ar² each independently represent an aromatic hydrocarbon group having 6 to 20 carbon atoms. n^{x9} represents an integer of 3 to 20.)

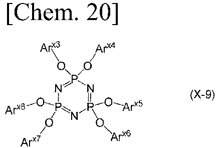

(In the formula, Ar^{x3} to Ar^{x8} each independently represent an aromatic hydrocarbon group having 6 to 20 carbon atoms.)

The explanation of the aromatic hydrocarbon group having 6 to 20 carbon atoms represented by Ar^{x1} and Ar^{x2} in the above general formula (X-8), and the aromatic hydrocarbon group having 6 to 20 carbon atoms represented by Ar^{x3} to Ar^{x8} in the above general formula (X-9) is the same as the explanation of the aromatic hydrocarbon group having 6 to 20 carbon atoms represented by R^{x12} and R^{x13} in the above general formula (X-7).

n^{X9} in the above general formula (X-8) preferably represents an integer of 3 to 20, preferably an integer of 3 to 10, more preferably an integer of 3 to 5, and even more preferably 3.

### ((Y) Flame retardant other than the phosphorus compound-based flame retardant)

The resin composition of the present embodiment contains a flame retardant other than the phosphorus compound-based flame retardant as the component (Y). The flame retardant other than the phosphorus compound-based flame retardant is preferably a flame retardant having a flame retardant mechanism different from that of the phosphorus compound-based flame retardant. Here, "having a flame retardant mechanism different from the above-mentioned phosphorus compound-based flame retardant" means that it does not have the same flame retardant mechanism as the above-mentioned phosphorus compound-based flame retardant. As for the flame retardant mechanism different from the above-mentioned phosphorus compound-based flame retardant, there is no particular limitation, and for example, a flame retardant mechanism in which burning is suppressed by stabilizing active OH radicals through radical trapping can be mentioned.

As a flame retardant having a flame retardant mechanism different from the above-mentioned phosphorus compound-based flame retardant, a halogen-based flame retardant is preferred. It is considered that, by the resin composition of the present embodiment containing both the component (X) and the halogen-based flame retardant, phosphorus halide and oxyhalide are generated, and since these exhibit excellent radical-trapping effects, a synergistic effect in flame retardancy is easily obtained. From the viewpoint of the flame retardant mechanism, in this embodiment, a compound having both phosphorus and a halogen is classified as the component (Y), not as the component (X).

The halogen-based flame retardant may be either a low molecular weight compound or a high molecular weight compound. The molecular weight of the low molecular weight compound is not particularly limited, and is preferably 1,500 or less, more preferably 200 to 1,500, even more preferably 500 to 1,300, further more preferably 700 to 1,200, particularly preferably 800 to 1,100, and most preferably 900 to 1,100. The molecular weight of the polymer compound is not particularly limited, and is preferably more than 1,500, more preferably more than 1,500 to 30,000, even more preferably 2,000 to 20,000, and particularly preferably 2,000 to 15,000.

Examples of halogen-based flame retardants include chlorine compounds and bromine compounds. Among these, as the halogen-based flame retardant, bromine compounds are preferred.

Examples of the chlorine compound include a chain aliphatic chlorine compound and a cyclic aliphatic chlorine compound. Here, a chain aliphatic chlorine compound is a compound having a site where a chlorine atom is directly bonded to a chain aliphatic hydrocarbon group, and a cyclic aliphatic chlorine compound is a compound having a site where a chlorine atom is directly bonded to a cyclic aliphatic hydrocarbon group.

Examples of the bromine compound include a chain aliphatic bromine compound, a cyclic aliphatic bromine compound, and an aromatic bromine compound. Here, a chain aliphatic chlorine compound is a compound having a site where a bromine atom is directly bonded to a chain aliphatic hydrocarbon group, and a cyclic aliphatic chlorine compound is a compound having a site where a bromine atom is directly bonded to a cyclic aliphatic hydrocarbon group. Also, an aromatic bromine compound is a compound that has a site where a bromine atom is bonded to an aromatic ring, but compounds that also have a site where the bromine atom is bonded to an aliphatic hydrocarbon group are not included. Among these, as the bromine compound, an aromatic bromine compound is preferred from the viewpoint of low thermal expansion, high elasticity, and a reduction of transmission loss. Specific examples of the bromine compound include the following compounds.

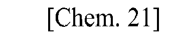

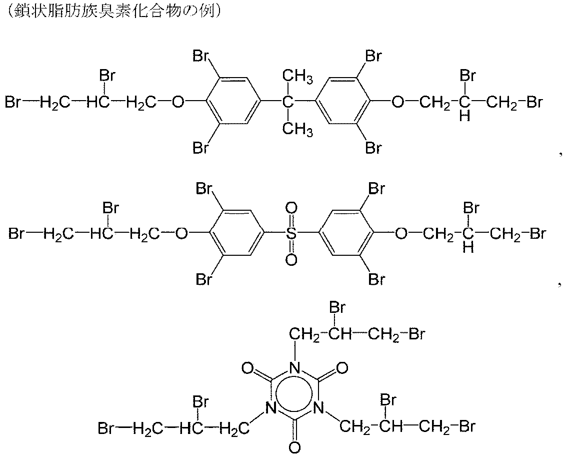

### Example of chain aliphatic bromine compounds

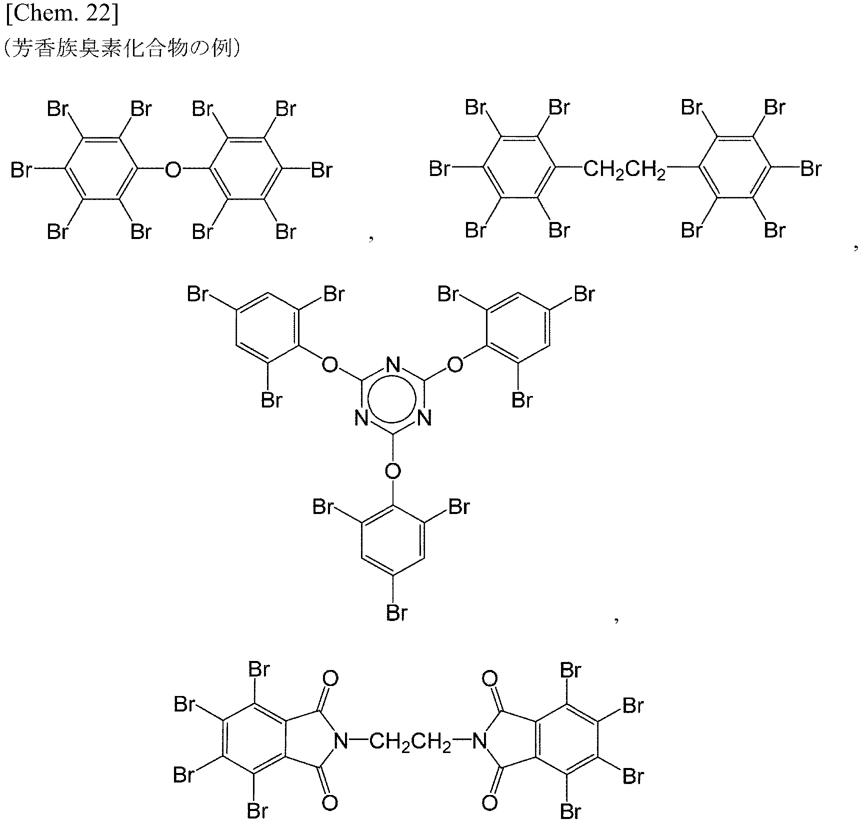

### Example of aromatic bromine compounds

### (Content of the Component (X) and the Component (Y))

The content of the component (X) and the component (Y) in the resin composition of the present embodiment is not particularly limited. For example, with respect to 100 parts by mass of the solid content in the resin composition, it is preferable that the component (X) is 0.5 to 10 parts by mass and the component (Y) is 0.5 to 20 parts by mass, it is more preferable that the component (X) is 1.0 to 7 parts by mass and the component (Y) is 3 to 18 parts by mass, it is even more preferable that the component (X) is 1.0 to 8 parts by mass and the component (Y) is 5 to 17 parts by mass, and it is particularly preferably that the component (X) is 1.5 to 6.5 parts by mass and the component (Y) is 8 to 16 parts by mass. When the contents of the component (X) and the component (Y) are within the above-mentioned numerical ranges, the dielectric dissipation factor (Df) is small, resulting in a reduction of transmission loss, and a synergistic effect of flame retardancy is obtained, and the appearance of the laminate also tends to be good.

### ((X1) Filler-type flame retardant and (Y1) Filler-type flame retardant)

In the present embodiment, when the component (X) does not contain the filler-type flame retardant (X1) and the component (Y) does not contain the filler-type flame retardant (Y1), or when either the component (X) contains the filler-type flame retardant (X1) or the component (Y) contains the filler-type flame retardant (Y1), a total content of the filler-type flame retardant (X1) and the filler-type flame retardant (Y1) are limited to a predetermined amount.

In the present disclosure, the term "filler-type" refers to a flame retardant that does not dissolve in the resin varnish when an organic solvent is added to the resin composition to prepare the resin varnish. Whether the flame retardant dissolves in the resin varnish is determined by visually observing the state of the flame retardant after adding 17 parts by mass of the flame retardant into 83 parts by mass of the resin varnish and stirring at 25°C for 30 minutes. When a flame retardant can be confirmed in the resin varnish, it is determined to be a filler-type flame retardant. Note that the organic solvent is the same as the organic solvent that may be contained in the resin varnish described below. The organic solvent may be, for example, an aromatic hydrocarbon solvent or toluene.

Here, since the filler-type flame retardant (Y1) is assumed to be a flame retardant as the component (Y), it is different from the filler-type flame retardant (X1).

As the filler-type flame retardant (X1), there is no particular limitation, and examples thereof include the metal salt of phosphinic acid (X-iv), and more specifically, tris(diethylphosphinic acid) aluminum. For example, 1,3-phenylene bis(di-2,6-xylenyl phosphate), which is a powder at 25°C, is soluble in organic solvents (e.g., aromatic hydrocarbon solvents such as toluene) and is therefore compatible with resin varnishes, but is not filler-type. In addition, 1,3-phenylene bis(diphenyl phosphate), which is a liquid at 25°C, and bisphenol A bis(diphenyl phosphate), which is a liquid at 25° C, and the like, are also compatible with resin varnishes, but are not filler-type.

The filler-type flame retardant (Y1) is not particularly limited, and examples thereof include ethylene bis pentabromobenzene and 1,2-bis (2,4,6-tribromophenoxy) ethane. For example, tris(tribromophenoxy)triazine, tribromophenol, tetrabromobisphenol A, which are powders at 25°C, are soluble in organic solvents (for example, aromatic hydrocarbon solvents such as toluene) and are not filler-type.

### (Total content of component (X1) and component (Y1))

In the resin composition of the present embodiment, when the component (X) contains the filler-type flame retardant (X1) or the component (Y) contains the filler-type flame retardant (Y1), a total content of the filler-type flame retardant (X1) and the filler-type flame retardant (Y1) are 25 parts by mass or less with respect to 100 parts by mass of solid content in the resin composition. By limiting the content of the filler-type flame retardant to the above range, the improvement effect on the appearance of the laminate becomes greater.

From the same viewpoint, in the resin composition of the present embodiment, a total content of the filler-type flame retardant (X1) and the filler flame retardant (Y1) are preferably 0 to 20 parts by mass, more preferably 0 to 18 parts by mass, and even more preferably 0 to 15 parts by mass, with respect to 100 parts by mass of the solid content in the resin composition. It may be 1 to 25 parts by mass, 3 to 20 parts by mass, 5 to 20 parts by mass, 8 to 20 parts by mass, 10 to 20 parts by mass, 10 to 18 parts by mass, or 10 to 15 parts by mass.

### (Ratio of the Content of the Component (X1) to the Content of the Component (Y1))

When the resin composition of the present embodiment contains both the content of the filler-type flame retardant (X1) and the filler-type flame retardant (Y1), the ratio of the content of the filler-type flame retardant (X1) to the content of the filler-type flame retardant (Y1): [(X1)/(Y1)] is not particularly limited, and from the viewpoint of flame retardancy and the balance between low transmission loss and the appearance of the laminate, it is preferably 1/99 to 45/55, more preferably 5/95 to 40/60, and may also be 5/95 to 35/65, 10/90 to 30/70, 10/90 to 25/75, 15/85 to 50/50, 20/80 to 45/55, or 25/75 to 45/55 as a mass ratio.

### (Compatible flame retardant (X2) and Compatible flame retardant (Y2))

In the resin composition of the present embodiment, from the viewpoint of the appearance of the laminate, the component (X) may contain (X2) a compatible flame retardant, and it is preferable that the component (X) contains the compatible flame retardant (X2). Furthermore, in the resin composition of the present embodiment, from the viewpoint of the appearance of the laminate, the component (Y) may contain (Y2) a compatible flame retardant, and it is preferable that the component (Y) contains the compatible flame retardant (Y2).

In the present disclosure, the term "compatible" refers to a flame retardant that dissolve in the resin varnish when an organic solvent is added to the resin composition to prepare the resin varnish. Whether the flame retardant dissolves in the resin varnish is determined by visually observing the state of the flame retardant after adding 17 parts by mass of the flame retardant into 83 parts by mass of the resin varnish and stirring at 25°C for 30 minutes. When a flame retardant cannot be confirmed in the resin varnish, it is determined to be a compatible flame retardant. Note that the organic solvent is the same as the organic solvent that may be contained in the resin varnish described below. The organic solvent may be, for example, an aromatic hydrocarbon solvent or toluene.

Here, since the compatible flame retardant (Y2) is assumed to be a flame retardant as the component (Y), it is different from the compatible flame retardant (X2).

The compatible flame retardant (X2) is not particularly limited, and examples thereof include the above-mentioned phosphate compound (X-i) and phosphine oxide compound (X-ii), and more specifically, includes 1,3-phenylene-bis(di-2,6-dimethylphenylphosphate), triphenylphosphine oxide.

The compatible flame retardant (Y2) is not particularly limited, and examples thereof include the following halogen-based flame retardants.

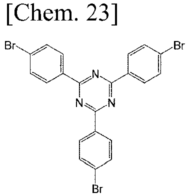

### (Content of the Component (X2) and Content of the Component (Y2))

In the resin composition of the present embodiment, when the component (X) contains the compatible flame retardant (X2), the content of the component (X2) is not particularly limited, and from the viewpoints of a reduction of transmission loss, flame retardancy, and the appearance of the laminate, it is preferably 0.5 to 10 parts by mass, more preferably 1 to 7 parts by mass, and even more preferably 2 to 5 parts by mass, with respect to 100 parts by mass of the solid content in the resin composition.

Furthermore, in the resin composition of the present embodiment, when the component (Y) contains the compatible flame retardant (Y2), the content of the component (Y2) is not particularly limited, and from the viewpoints of a reduction of transmission loss, flame retardancy, and the appearance of the laminate, the content is preferably 0.5 to 17 parts by mass, more preferably 1 to 15 parts by mass, and even more preferably 2 to 13 parts by mass, or may be 2 to 7 parts by mass, or may be 7 to 17 parts by mass, with respect to 100 parts by mass of the solid content in the resin composition.

### ((C) Inorganic Filler)

When the resin composition of the present embodiment contains an inorganic filler [hereinafter sometimes referred to as component (C)] as the component (C), the low thermal expansion coefficient, elastic modulus, heat resistance, and flame retardancy tend to be improved.

The component (C) may be used alone or in combination of two or more thereof.

Examples of the component (C) include, for example, silica, alumina, titanium oxide, mica, beryllia, barium titanate, potassium titanate, strontium titanate, calcium titanate, aluminum carbonate, magnesium hydroxide, aluminum hydroxide, aluminum silicate, calcium carbonate, calcium silicate, magnesium silicate, silicon nitride, boron nitride, clay (baked clay, and the like), a molybdic acid compound such as zinc molybdate, talc, aluminum borate, and silicon carbide. Of these, silica, alumina, mica, and talc are preferred, silica and alumina are more preferred, and silica is even more preferred, from the viewpoints of low thermal expansion, elastic modulus, heat resistance, and flame retardancy.

Examples of the silica include crushed silica, fumed silica, and fused silica.

The average particle size of the component (C) is not particularly limited, it is preferably 0.01 to 20 µm, more preferably 0.1 to 10 µm, even more preferably 0.2 to 1 µm, and particularly preferably 0.3 to 0.8 µm.

The shape of the component (C) may be spherical, pulverized, and the like, and it is not particularly limited, however it is preferably spherical.

When the resin composition of the present embodiment contains the component (C), although the content of the component (C) in the resin composition is not particularly limited, and from the viewpoint of low thermal expansion, elastic modulus, and heat resistance, it is preferably 5 to 70 parts by mass, more preferably 15 to 65 parts by mass, even more preferably 20 to 60 parts by mass, particularly preferably 30 to 55 parts by mass, and most preferably 40 to 55 parts by mass, with respect to 100 parts by mass of the solid content in the resin composition.

When the resin composition of the present embodiment contains the component (C), a coupling agent may be used for the purpose of improving the dispersibility of the component (C) and the adhesion to an organic component. The coupling agent is preferably a silane coupling agent. Examples of the silane coupling agent include aminosilane coupling agents, epoxysilane coupling agents, phenylsilane coupling agents, alkylsilane coupling agents, alkenylsilane coupling agents, alkynylsilane coupling agents, and silicone oligomer coupling agents. These coupling agents may be used alone or in combination of two or more kinds thereof.

When a coupling agent is used, a surface processing method for the component (C) may be an integral blend treatment method in which the coupling agent is added after the component (C) is blended in the resin composition, or may be a method of previously subjecting the component (C) to a surface treatment with the coupling agent in a dry or wet mode. Of these, the method of previously subjecting the component (C) to a surface treatment with the coupling agent in a dry or wet mode is preferable from the viewpoint of more effectively revealing the advantages of the component (C).

For the purpose of improving dispersibility in the resin composition, the component (C) may be made into a state of slurry in which it is previously dispersed in an organic solvent and then mixed with other components.

### ((D) Curing accelerator)

When the resin composition of the present embodiment contains a curing accelerator as the component (D) [hereinafter, may be referred to as component (D)], the curability is improved, and there is a tendency for improvement in elastic modulus, a reduction of transmission loss, heat resistance, and adhesion to conductors.

The component (D) may be used alone or in combination of two or more thereof.

Examples of the component (D) include acidic catalysts such as p-toluenesulfonic acid; amine compounds such as triethylamine, pyridine, and tributylamine; imidazole compounds such as methylimidazole and phenylimidazole; isocyanate-masked imidazole compounds such as an addition reaction product of hexamethylene diisocyanate resin and 2-ethyl-4-methylimidazole; tertiary amine compounds; quaternary ammonium compounds; organic peroxides such as dicumyl peroxide, 2,5-dimethyl-2,5-bis(t-butylperoxy)hexyne-3,2,5-dimethyl-2,5-bis(t-butylperoxy)hexane, t-butylperoxyisopropyl monocarbonate, and α,α'-bis(t-butylperoxy)diisopropylbenzene; and carboxylates of manganese, cobalt, and zinc.

Of these, from the viewpoint of heat resistance and storage stability, imidazole compounds, isocyanate-masked imidazole compounds, organic peroxides, and carboxylates are preferred, organic peroxides are more preferred, and α,α'-bis(t-butylperoxy)diisopropylbenzene is even more preferred.

When the resin composition of the present embodiment contains the component (D), although the content of the component (D) is not particularly limited, it is preferably 0.01 to 10 parts by mass, more preferably 0.05 to 8 parts by mass, even more preferably 0.1 to 6 parts by mass, and particularly preferably 0.2 to 3 parts by mass, with respect to 100 parts by mass of the total resin components in the resin composition. When the content of the component (D) is equal to or greater than the lower limit value, the elastic modulus, a reduction of transmission loss, heat resistance, and adhesion to conductors tend to be improved. Moreover, when the content of the component (D) is equal to or less than the upper limit value, storage stability of the resin composition tends to be further improved.

### (Other components)

The resin composition of the present embodiment may further contain, if necessary, one or more selected from the group consisting of a resin material other than the above-mentioned components, an antioxidant, a flame retardant, a flame retardant synergists, a thermal stabilizer, an antistatic agent, an ultraviolet absorber, a pigment, a colorant, a lubricant, and additives other than these. Each of these may be used alone or in combination of two or more thereof. Moreover, the amount of these to be used is not particularly limited, and may be used as necessary within a range that does not impair the effects of the present embodiment.

The resin composition of the present embodiment may be in a state of being dissolved or dispersed in an organic solvent, that is, in a state of a so-called "resin varnish". Hereinafter, a resin composition containing an organic solvent may be referred to as a resin varnish.

Examples of the organic solvent include ketone-based solvents such as acetone, methyl ethyl ketone, methyl isobutyl ketone, and cyclohexanone; aromatic hydrocarbon-based solvents such as toluene and xylene; ester-based solvents such as methoxyethyl acetate, ethoxyethyl acetate, butoxyethyl acetate, and ethyl acetate; amide-based solvents such as N-methylpyrrolidone, formamide, N-methylformamide, and N,N-dimethylacetamide; and alcohol-based solvents such as methanol, ethanol, ethylene glycol, ethylene glycol monomethyl ether, ethylene glycol monoethyl ether, diethylene glycol, triethylene glycol monomethyl ether, triethylene glycol monoethyl ether, triethylene glycol, propylene glycol monomethyl ether, dipropylene glycol monomethyl ether, propylene glycol monopropyl ether, and dipropylene glycol monopropyl ether. These organic solvents may be used alone or in combination of two or more kinds thereof.

The solid content concentration in the resin varnish is preferably from 10 to 70% by mass, more preferably from 20 to 60% by mass, and even more preferably from 35 to 60% by mass.

### [Prepreg]

The prepreg of the present embodiment is a prepreg containing the resin composition of the present embodiment or a semi-cured product of the resin composition.

The prepreg of the present embodiment contains, for example, the resin composition of the present embodiment or a semi-cured product of the resin composition and a sheet-like fibrous base material. The prepreg is formed using the resin composition or a resin film of the present embodiment, and the sheet-like fibrous base material, and it can be obtained, for example, by impregnating or coating the resin composition or a resin film of the present embodiment into the sheet-shaped fiber base material, drying, and semi-curing (B-staging) the product as necessary. More specifically, for example, the prepreg of the present embodiment can be produced by semi-curing (B-staging) by heating and drying usually at a temperature of 80 to 200°C for 1 to 30 minutes in a drying furnace. Here, in the present disclosure, B-staging is to bring into a B-stage state as defined in JIS K6900 (1994).

The amount of the resin composition to be used can be appropriately determined for the purpose of setting the solid content concentration derived from the resin composition in the prepreg after drying to 30 to 90% by mass. When the solid content concentration is set to be in the above-described range, better moldability tends to be obtained when a laminate is formed.

As the sheet-like fibrous base material of the prepreg, known materials used for various laminates for electrical insulating materials can be used. Although the sheet-like fibrous base material is not particularly limited, it is, for example, preferably a sheet-like fiber-reinforced base material used for the purpose of reinforcing the prepreg. Examples of materials for the sheet-like fibrous base material include inorganic fibers, such as E glass, D glass, S glass, and Q glass; organic fibers, such as polyimide, polyester, and tetrafluoroethylene; and mixtures thereof. These sheet-like fibrous base materials have shapes of, for example, woven fabrics, non-woven fabrics, robinks, chopped strand mats, or surfacing mats.

The thickness of the sheet-like fibrous base material is not particularly limited, and for example, one having a thickness of 0.02 to 0.5 mm can be used.

Furthermore, as the sheet-like fibrous base material, one having been subjected to a surface treatment with a coupling agent or the like, or one having been subjected to a fiber opening treatment mechanically, can be used from the viewpoint of the impregnating property of the resin composition, and the heat resistance, moisture absorption resistance and workability at the time of forming into a laminated board.

As a method for impregnating or coating a sheet-like fibrous base material with the resin composition, a hot melt method, a solvent method, or the like can be used.

The hot melt method refers to a process in which no organic solvent is contained in the resin composition, and includes either: (1) coating the resin composition onto a coated paper having good releasability from the resin composition, followed by laminating the coated layer onto a sheet-shaped fibrous base material; or (2) applying the resin composition onto a sheet-like fibrous base material using a die coater.

On the other hand, the solvent method is a method in which an organic solvent is added to a resin composition, and a sheet-like fibrous base material is immersed in the obtained resin composition to impregnate the sheet-like fiberous base material with the resin composition, and then it is dried.

### [Resin Film]

The resin film of the present embodiment is a resin film containing the resin composition of the present embodiment or a semi-cured product of the resin composition.

The resin film of the present embodiment can be produced, for example, by applying a resin composition containing an organic solvent, that is, a resin varnish, to a support, heating and drying the varnish, and semi-curing (B-staging) the varnish as necessary.

Examples of the support include a film of polyolefin such as polyethylene, polypropylene, and polyvinyl chloride; a film of polyester such as polyethylene terephthalate (hereinafter, also referred to as "PET") and polyethylene naphthalate; various plastic films such as a polycarbonate film and a polyimide film. As the support, a metal foil such as copper foil or aluminum foil, release paper, etc. may be used. The support may be surface-treated by a mat treatment, a corona treatment, or the like. In addition, the support may be release-treated with a silicone resin-based releasing agent, an alkyd resin-based releasing agent, a fluororesin-based releasing agent, or the like.

The thickness of the support is not particularly limited, and is preferably 10 to 150 µm, and more preferably 25 to 50 µm.

A method for coating the resin varnish to a support is not particularly limited, and a coating device known to those skilled in the art, such as a comma coater, a bar coater, a kiss coater, a roll coater, a gravure coater, and a die coater can be used. These coating devices may be properly selected according to the film thickness.

The drying temperature and the drying time may be determined depending on the amount of the organic solvent used, the boiling point of the organic solvent to be used. For example, in the case of a resin varnish containing 40 to 60% by mass of an organic solvent, a resin film can be suitably formed by drying at 50 to 150°C for 3 to 10 minutes.

### [Laminate]

The laminate of the present embodiment is a laminate containing one or more selected from the group consisting of a cured product of the resin composition of the present embodiment, a cured product of the prepreg, and a cured product of the resin film, and a metal foil.

The laminate of the present embodiment can be produced by, for example, disposing a metal foil on one surface or both surfaces of one prepreg of the present embodiment, or disposing a metal foil on one surface or both surfaces of a prepreg obtained by stacking two or more (preferably 2 to 30 and more preferably 2 to 15) prepreg of the present embodiment, and then performing heat and press forming.

In the laminate obtained by the production method, the prepreg of the present embodiment is C-staged. In the present disclosure, C-staging is to bring into a C-stage state as defined in JIS K6900 (1994). A laminate having a metal foil is sometimes referred to as a metal-clad laminate.

The metal of the metal foil is not particularly limited, and from the viewpoint of conductivity, the metal may be copper, gold, silver, nickel, platinum, molybdenum, ruthenium, aluminum, tungsten, iron, titanium, chromium, or an alloy containing one or more of these metallic elements, and is preferably copper or aluminum, and more preferably copper.

The conditions of the heating press molding are not particularly limited, and the heating press molding can be carried out, for example, at a temperature of 100 to 300°C, a pressure of 0.2 to 10 MPa, and a time of 0.1 to 5 hours. In addition, as the heat and pressure molding, a method of maintaining a vacuum state for 0.5 to 5 hours using a vacuum press or the like can be adopted.

### [Printed Wiring Board]

The printed wiring board of the present embodiment has one or more selected from the group consisting of a cured product of the resin composition of the present embodiment, a cured product of the prepreg, and the laminate of the present embodiment. The printed wiring board of the present embodiment can be produced by using one or more selected from the group consisting of the prepreg of the present embodiment, the resin film of the present embodiment, and the laminate of the present embodiment, and performing circuit formation processing by drilling, metal plating, etching of a metal foil, or the like by a known method. Furthermore, a multilayer printed wiring board can be produced by performing multilayer bonding processing as necessary. In the printed wiring board of the present embodiment, the prepreg of the present embodiment or the resin film of the present embodiment is in C-staging.

### [Semiconductor Package]

The semiconductor package is a semiconductor package including the printed wiring board and a semiconductor element. The semiconductor package of the present embodiment can be produced, by mounting a semiconductor element such as a semiconductor chip or a memory on a predetermined position of the printed wiring board of the present embodiment and sealing the semiconductor element with a sealing resin.

The resin composition, the prepreg, the resin film, the laminate, the printed wiring board, and the semiconductor package of the present embodiment can be suitably used in an electronic device that handles a high-frequency signal of 10 GHz or more. In particular, the printed wiring board is useful as printed wiring boards for millimeter wave radars.

### Example

Hereinafter, the present embodiment will be specifically described with reference to Examples. However, the present embodiment is not limited to the following Examples.

In each example, the number-average molecular weight and the weight-average molecular weight (Mw) were measured by the following procedure.

### (I. Measurement Method of Number-Average Molecular Weight (Mn) and Weight-Average Molecular Weight (Mw))

The number average molecular weight and the weight average molecular weight were converted from a calibration curve using standard polystyrene by gel permeation chromatography (GPC). The calibration curve was approximated according to a cubic equation using standard polystyrene: TSKstandard POLYSTYRENE (Type: A-2500, A-5000, F-1, F-2, F-4, F-10, F-20, F-40) [a trade name, manufactured by Tosoh Corporation]. Measurement conditions of GPC are as follows.
Apparatus: High-speed GPC apparatus HLC-8320GPC
Detector: UV absorption detector UV-8320 [manufactured by Tosoh Corporation]
Column: Guard column; TSK Guardcolumn SuperHZ-L + column; TSKgel SuperHZM-N + TSKgel SuperHZM-M + TSKgel SuperH-RC (trade names, all manufactured by Tosoh Corporation)
Column size: 4.6 × 20 mm (guard column), 4.6 × 150 mm (column), 6.0 × 150 mm (reference column)
Eluent: Tetrahydrofuran
Sample concentration: 10mg/5mL
Injection volume: 25 µL
Flow rate: 1.00 mL/min
Measurement temperature: 40°C

### (II. Measurement of Vinyl Group Modification Rate)

The value obtained by the following method was defined as the modification rate of the vinyl group in the modified conjugated diene polymer B1-1 prepared in Production Example 1.

GPC measurement was conducted by the same method for the liquid containing the component (b1) and the component (b2) before the reaction, and for the liquid containing the modified conjugated diene polymer obtained after the reaction. The decrease rate of the peak area derived from the component (b2) before and after the reaction-namely, (peak area derived from the component (b2) before the reaction - peak area derived from the component (b2) after the reaction) × 100 / (peak area derived from the component (b2) before the reaction)-was calculated, and the obtained value was defined as the modification rate of the vinyl group.

### Production Example 1 (Production of Modified Conjugated Diene Polymer B1-1)

The component (b1) and the component (b2) in the amounts shown in Table 1, an organic peroxide, and toluene as an organic solvent were charged into a 2-liter glass flask container equipped with a thermometer, reflux condenser, and stirring device, and capable of heating and cooling. Under a nitrogen atmosphere, the mixture was reacted at 90 to 100 °C for 5 hours with stirring, to obtain a liquid (toluene dilution, solid content concentration: 35 mass%) containing the modified conjugated diene polymer B1-1.

The vinyl group modification rate and number average molecular weight of the resulting modified conjugated diene polymer B1-1 are shown in Table 1.

### [Table 1]

**Table 1**

| | | | Production Example 1 |
|---|---|---|---|
| | | | B1-1 |
| (b1) | Polybutadiene 1 | Parts by mass | 33.5 |
| (b2) | Bismaleimide compound 1 | Parts by mass | 1.48 |
| Reaction catalyst | Organic peroxide | Parts by mass | 0.034 |
| Physical properties | Vinyl Group Modification Rate | % | 40 |
| | Number average molecular weight (Mn) | - | 1,900 |

The details of each component described in Table 1 are as follows.
[Component (b1)]
   - Polybutadiene 1: 1,2-polybutadiene homopolymer, number average molecular weight = 1,200, vinyl group content = 85% or more
[Component (b2)]
   - Bismaleimide compound 1: 4,4'-diphenylmethane bismaleimide
[Reaction catalyst]
   - Organic peroxide: α,α'-bis(t-butylperoxy)diisopropylbenzene

### Examples 1 to 6 and Comparative Examples 1 to 3

### (Preparation of Resin composition and Resin varnish)

Each component shown in Table 2 was blended in the blending amounts indicated in Table 2 (the blending amounts described in Table 2 are in parts by mass of solid content), and by mixing them in toluene, a resin composition (resin varnish) with a non-volatile content (solid content concentration) of 50 mass% was obtained. In Table 2, the unit of the blending amount of each component is parts by mass, and in the case of a solution or a dispersion, the unit means parts by mass in terms of solid content.

### (Production of Prepreg)

The resin varnish prepared in each example was impregnated into glass cloth (manufactured by NITTO BOSEKI CO., LTD., #1078 type, #2116 type), and then dried by heating at 120°C for 5 minutes to obtain a prepreg. The content of the resin composition in the prepreg using #1078 type glass cloth (for evaluation of transmission loss and appearance) was set to 66 mass%, and the content of the resin composition in the prepreg using #2116 type glass cloth (for flame retardancy evaluation) was set to 57 mass%.

The flame retardancy was evaluated by using the prepreg using #2116 type glass cloth according to the measurement method described later.

### (Production of Double-Sided Copper-Clad Laminate)

A 12 µm-thick electrolytic copper foil "3EC-M3-VLP-18" (product name, manufactured by Mitsui Mining & Smelting Co., Ltd.) was laminated on both sides of six laminated prepregs (prepregs using #1078 type glass cloth) so that the adhesive surfaces faced the prepregs, and the laminate was heated and pressed at 180°C for 60 minutes under vacuum pressing conditions of 3 MPa to produce a double-sided copper-clad laminate.

Using the obtained double-sided copper-clad laminate, the evaluation of transmission loss and an appearance was performed according to the following methods. The results are shown in Table 2.

### [Measurement Methods]

### (1) Measurement method of Dielectric Dissipation Factor (Df)- transmission loss

An evaluation substrate of 2 mm × 50 mm was produced from an evaluation substrate obtained by removing the copper foil by immersing the double-sided copper clad laminate obtained in each example in a 10 mass% solution of ammonium persulfate which is a copper etching solution.

The dielectric dissipation factor (Df) was measured for the evaluation substrate in a 10 GHz band at an atmospheric temperature of 25°C in accordance with the cavity resonator perturbation method.

The dielectric dissipation factor (Df) is preferably 0.0020 or less, more preferably 0.0018 or less, and even more preferably 0.0017 or less.

### (2) Burn time - Flame retardancy

The prepregs obtained in each example (prepregs using #2116 type glass cloth) were laminated to a thickness of 1.6 mm, and electrolytic copper foils "3EC-M3-VLP-18" (product name, manufactured by Mitsui Smelting & Co., Ltd.) were placed on top and bottom so that the adhesive surfaces faced the prepregs, and heating and pressing were performed at 180°C for 60 minutes under vacuum pressing conditions of 3 MPa to produce double-sided copper clad laminates. The obtained double-sided copper clad laminate was immersed in a 10% by mass solution of ammonium persulfate as a copper etching solution to remove the copper foil, and then cut into five evaluation substrates with a size of 1.3 cm × 12.5 cm. A vertical burning test (UL 94 flammability test) was conducted on each of the obtained five evaluation substrates, and for each, the burn times of the first and second flame application were measured by applying a flame twice. The average burn time across the five test boards was calculated. In both the first and second flame applications, the average burn time is preferably 10 seconds or less, more preferably 7 seconds or less, and even more preferably 5 seconds or less.

### (3) Appearance

An evaluation substrate which was obtained by removing the copper foil by immersing the double-sided copper clad laminate obtained in each example in a 10 mass% solution of ammonium persulfate which is a copper etching solution, was visually observed and evaluated according to the following evaluation criteria.
A: No fading was observed anywhere on the surface
B: Fading was observed only at the edges.
C: Fading was observed at least in the central portion.

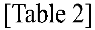

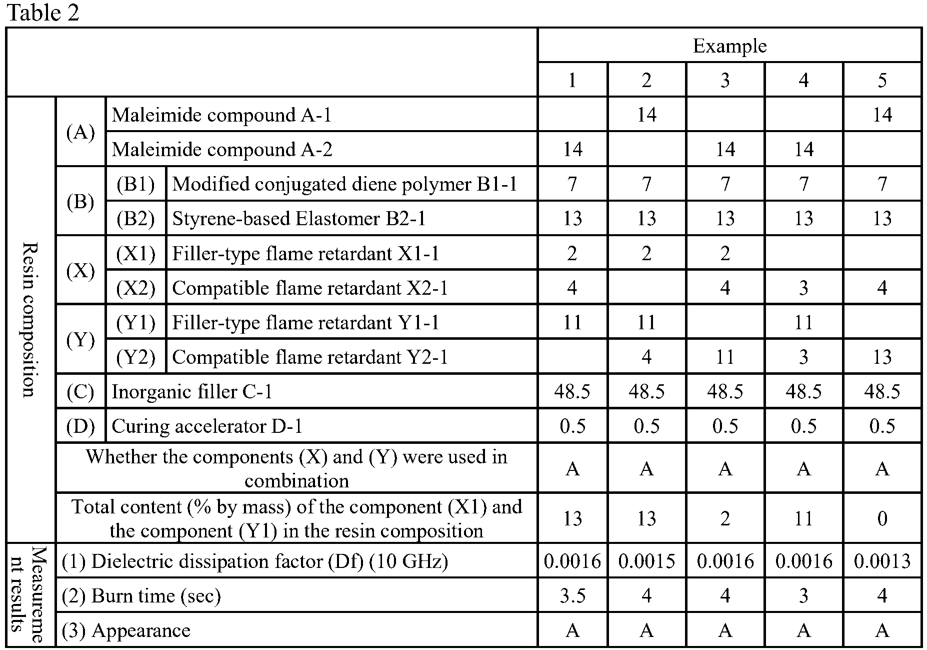

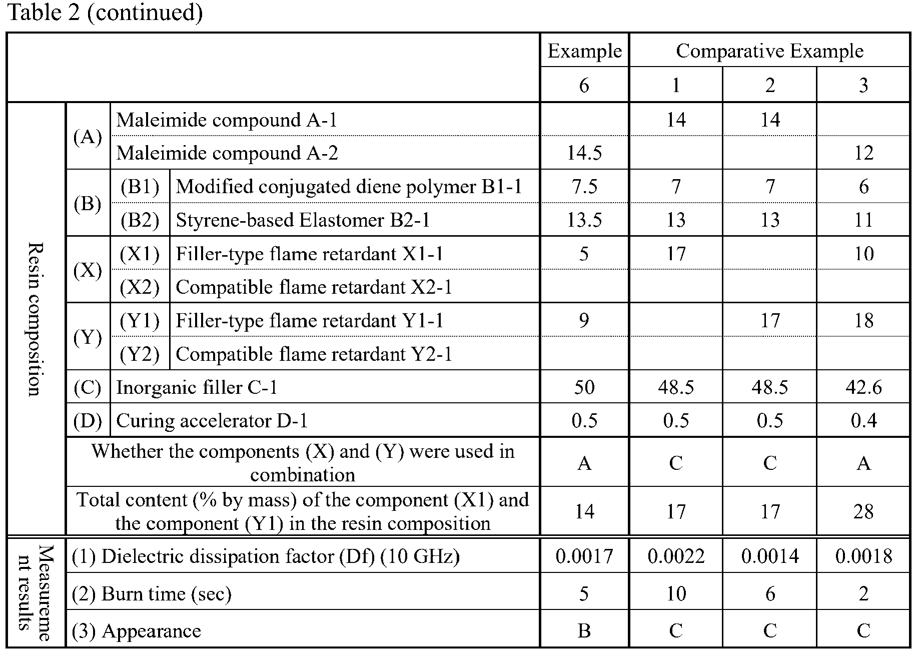

The details of the components described in Table 2 are as follows.

### [Component (A)]

- Maleimide compound A-1: indane ring-containing aromatic bismaleimide (Number average molecular weight; 1,200)
- Maleimide compound having a biphenylaralkyl skeleton "MIR-3000" (product name, manufactured by Nippon Kayaku Co., Ltd.)

### [Component (B)]

- Modified conjugated diene polymer B1-1: a modified conjugated diene polymer B1-1 obtained in Production Example 1
- Styrene-based elastomer B2-1: Hydrogenated product of styrene-butadiene-styrene block copolymer (SEBS), styrene content: 30 mass%, weight average molecular weight: 115,200

### [Component (X)]

- Component (X1): Filler-type flame retardant X1-1: aluminum tris(diethylphosphinate) (see structural formula below); 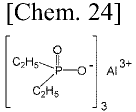
- Component (X2): Compatible flame retardant X2-1 : Phosphorus compound-based flame retardant having the following structure

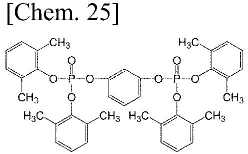

### [Component (Y)]

- Component (Y1): Filler-type flame retardant Y1-1 : Decabromodiphenylethane (see structure below); 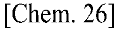 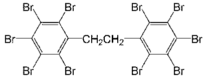
- Component (Y2): Compatible flame retardant Y2-1 : Halogen-based flame retardant having the following structure

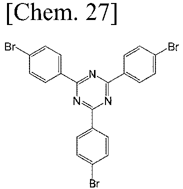

### [Component (C)]

- Inorganic filler C-1 : Silane coupling treated fused spherical silica, average particle size 0.5 µm

### [Component (D)]

- Curing accelerator D-1: α,α'-bis(t-butylperoxy)diisopropylbenzene

As is clear from Table 2, the double-sided copper-clad laminates obtained in each example have a low dielectric dissipation factor (Df), resulting in a reduction of transmission loss, excellent flame retardancy, and good appearance.

On the other hand, the double-sided copper-clad laminate from Comparative Example 1 has a high dielectric dissipation factor (Df), inferior flame retardancy compared to the Examples, and poor appearance. In Comparative Example 2, the dielectric dissipation factor (Df) is improved, and the flame retardancy is good, but the appearance is poor. In Comparative Example 3, the dielectric dissipation factor (Df) is relatively good, and while the flame retardancy is excellent, the appearance is poor. Thus, it is clear that achieving low transmission loss, excellent flame retardancy, and good appearance in a laminate is not easy.

## Claims

1. A resin composition comprising:
(A) a thermosetting resin;
(B) a polymer having a hydrocarbon chain or a polyether chain;
(X) a phosphorus compound-based flame retardant; and
(Y) a flame retardant other than the phosphorus compound-based flame retardant,
wherein the component (X) does not contain (X1) a filler-type flame retardant, and the component (Y) does not contain (Y1) a filler-type flame retardant, or,
wherein when the component (X) contains the filler-type flame retardant (X1) or the component (Y) contains the filler-type flame retardant (Y1), a total content of the filler-type flame retardant (X1) and the filler-type retardant (Y1) is 25 parts by mass or less with respect to 100 parts by mass of a solid content in the resin composition.

2. The resin composition according to claim 1,
wherein the component (X) contains (X2) a compatible flame retardant.

3. The resin composition according to claim 1,
wherein the component (Y) contains (Y2) a compatible flame retardant.

4. The resin composition according to claim 1,
wherein the component (A) contains at least one selected from the group consisting of an epoxy resin, a maleimide compound, a phenol resin, a polyimide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin.

5. The resin composition according to claim 1,
wherein the component (B) is at least one selected from the group consisting of a conjugated diene polymer, a styrene-based elastomer, and a modified product thereof.

6. The resin composition according to claim 1,
wherein the component (X) contains at least one selected from the group consisting of (X-i) a phosphate compound, (X-ii) a phosphine oxide compound, (X-iii) a phosphaphenanthrene compound, (X-iv) a metal salt of phosphinic acid, and (X-v) a nitrogen-containing organic phosphorus compound.

7. The resin composition according to claim 1,
wherein the component (X) contains two or more phosphorus atoms in one molecule.

8. The resin composition according to claim 1,
wherein the component (Y) is a halogen-based flame retardant.

9. The resin composition according to claim 1, further comprising:
(C) an inorganic filler.

10. The resin composition according to claim 1, further comprising:
(D) a curing accelerator.

11. A prepreg comprising:
the resin composition according to claim 1; or
a semi-cured product of the resin composition.

12. A resin film comprising:
the resin composition according to claim 1; or
a semi-cured product of the resin composition.

13. A laminate comprising:
a cured product of the resin composition according to claim 1; or
a cured product of the prepreg according to claim 11; and
a metal foil.

14. A printed wiring board comprising:
a cured product of the resin composition according to claim 1.

15. A semiconductor package comprising:
the printed wiring board according to claim 14; and
a semiconductor element.
